# EUROPEAN PATENT APPLICATION

(11) **EP 1 160 875 A1**
(43) Date of publication of application: **05.12.2001**
(21) Application number: 01111083.0
(22) Date of filing: 09.05.2001
(51) Int. Cl.: H01L 31/0203, H01L 33/00, G02B 6/42

(54) **Electro-optical element with a metal coated housing**

(30) Priority: 13.05.2000 EP 00110332
(71) Applicant: Tyco Electronics AMP GmbH, 64625 Bensheim (DE)
(72) Inventor: Loeffelholz, Stefan, 64653 Lorsch (DE); Reifel, Dirk, 95610 Eragny-sur-Oise (FR)
(74) Representative: Heinz-Schäfer, Marion

(57) **Abstract**

The invention relates to an electro-optical component such as a diode, having a housing (1) of synthetic material, which according to the invention is provided with a metal coating (3) to prevent electromagnetic compatibility problems.

## Description

The invention relates to an electro-optical component such as a diode, having a housing of synthetic material.

These electro-optical components having additional integrated circuits such as an evaluation logic unit or may experience electromagnetic interference problems at the electrical interface connection.

Not only may functioning of the diode and the integrated components be disrupted by outside interference, but the diode may generate interference effecting the neighbouring components.

If for example a plurality of diodes is operated in parallel in one optical pin header, this may result in mutual coupling known as cross-talk.

In the case of a partially optical pin header in which electrical pins may also be used, the signals from the electrical pins may interfere wit the neighbouring diodes.

For this reason, it is necessary to provide the diodes with a shield. Up until now, wire or metal cages or metal mesh inside which the diodes are built have been used. Similarly, it is known to use shield panels or metal housings.

However, the known shielding methods have the disadvantages that they require additional parts each needing separate assembly.

A further disadvantage is that these additional parts need a relatively large amount of space and thus prevent the diodes from being arranged in a very close grid pattern.

An object of the invention is therefore to provide a shielding arrangement in which the disadvantages listed above do not occur.

This and other objects are achieved in accordance with the invention in that the housing is provided with a metal coating for shielding.

This metal coating may be applied in a simple manner when the housing of the diodes is cast. There is no need for additional shielding measures such as shield panels or metal housings.

The diodes provided with a metallization layer may be used to replace unshielded diodes in a simple manner, since no special precautions have to be taken for the shielding.

Since the diode housings are mostly used on printed circuit boards, the metal coating has to be connected to the printed circuit board by means of an grounding contact.

This may be done for example using a contact spring, which presses against the metal coating and a solder connection, which is provided on the contact spring and through which the printed circuit board is brought into contact.

It is also possible in the case of the leadframe used for the diode to bring a leg into contact with the metal coating and to use it to make the grounding contact.

Furthermore, it is also possible to over mould a contact of oversized dimensions in a hole in the housing. This contact can be used to ground the shield.

A preferred embodiment provides for a geometric shape forming a contact pin to be moulded to the diode housing and to be metallized at the same time as the entire diode housing.

This means that the contact pin, shaped out of synthetic material and metallized, can be used for making electrical contact with the printed circuit board. Advantageously, the synthetic pin is made from a material, which withstands heating during a soldering procedure.

The synthetic pin may for example be moulded to the diode housing from a special material in a two-component injection procedure.

Advantageously, the geometric shape of the synthetic pin is selected such that heat is dissipated to the diode housing.

According to an alternative embodiment, the synthetic pin may also be constructed as an over moulded connection.

The invention will be explained in more detail below with reference to an embodiment illustrated in the drawings of which:

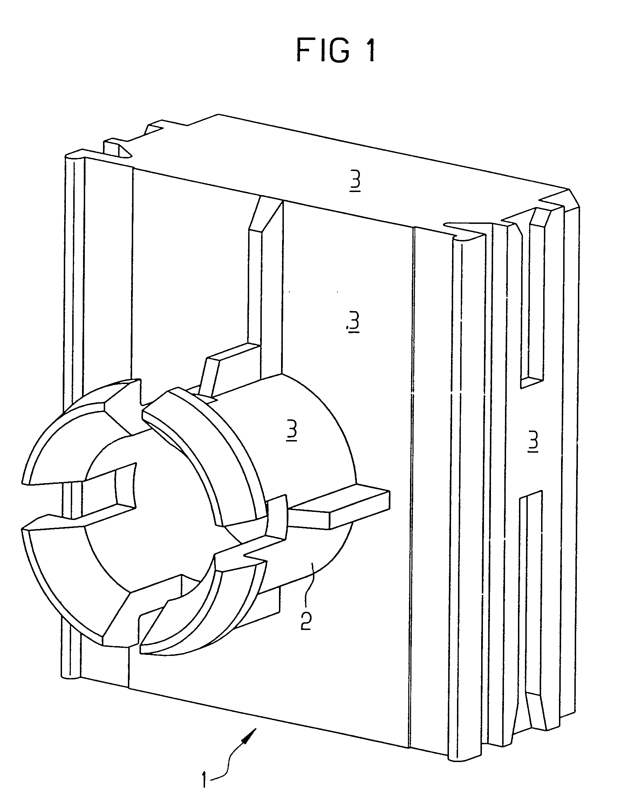

Figure 1 is a perspective view of the metallized diode housing; and
Figure 2 is a perspective view of a metallized diode housing having a synthetic pin and electrical contacts.

The invention will now be described in greater detail. A connection element 2 for an optical waveguide (not shown) is provided at the end face of the diode housing 1. The entire diode housing 1 is made from synthetic material and is provided with a metallized coating 3.

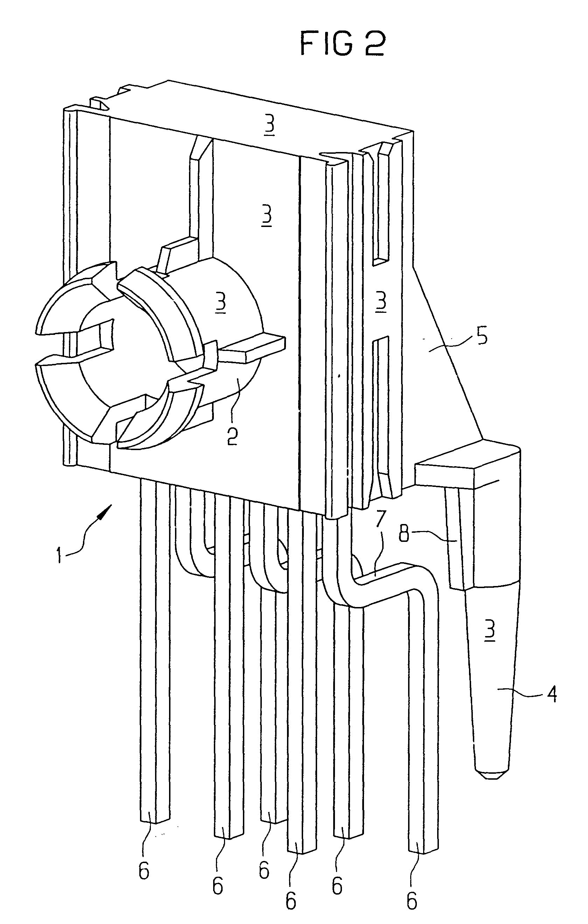

Referring to Figure 2, the diode housing 1 may have a synthetic pin 4, which is provided with a metallization layer 3.

The synthetic pin 4 serves to provide a ground connection through the metallization layer 3 to a ground contact on printed circuit board (not shown). The synthetic pin 4 is either pressed into a plated through hole in the printed circuit board, or is soldered to the printed circuit board.

The synthetic pin 4 is made from a heat-resistant synthetic material such as LCP with 30% glass fibres. Either the entire diode housing is made from the heat-resistant synthetic material, or the synthetic pin is moulded to the diode housing 1 by a two-component injection moulding process.

The shape of the synthetic pin 4 is selected such that during the soldering procedure the heat is dissipated in the direction of the diode housing. The synthetic pin 4 widens conically upwards and is connected to the diode housing 1 by way of a transition region 5.

The diode housing 1 illustrated in Figure 2 has electrical contacts 6 in the form of solder connections. The contacts 6 are arranged in two rows, with the contacts in the first row being straight and those in the second row being constructed to be laterally offset by a horizontal section 7.

Provided on the contact pin 4 is a stop 8 which is positioned at a height relative to the horizontal sections 7 and serves to prevent over insertion into the printed circuit board.

The invention is not restricted to the embodiment illustrated. The grounding contact of the metal coating 3 may for example also be made by way of a metal contact pin moulded in the diode housing 1 and electrically connected to the metal coating 3.

## Claims

1. An electro-optical component such as a diode, having a housing (1) of synthetic material, **characterised in that** the housing (1) is provided with a metal coating (3) for the purpose of shielding.

2. An electro-optical component according to Claim 1, **characterised in that** a synthetic pin (4) is moulded to the housing (1) and is also provided with the metal coating (3).

3. An electro-optical component according to Claim 2, **characterised in that** at least the synthetic pin (4) is made from a heat-resistant material.

4. An electro-optical component according to Claim 2 or 3, **characterised in that** the synthetic pin is shaped such that the heat which arises after a soldering procedure is dissipated.

5. An electro-optical component according to Claim 1, **characterised in that** a metal contact is moulded in the diode housing (1) and electrically connected to the metal coating (3).
